# EUROPEAN PATENT APPLICATION

(11) **EP 1 545 179 A1**
(43) Date of publication of application: **22.06.2005**
(21) Application number: 03028690.0
(22) Date of filing: 16.12.2003
(51) Int. Cl.: H05K 7/20, G06F 1/20

(54) **Integrated heat dissipating assembly for computer systems**

(71) Applicant: Shuttle Inc., Nei-Hu Dist., Taipei (TW)
(72) Inventor: Chen, Yin Hung, Taipei (TW)
(74) Representative: TER MEER STEINMEISTER & PARTNER GbR

(57) **Abstract**

A heat dissipation and airflow assembly is to provide a more effective and integrated solution for the heat dissipation need of a computer system. The assembly has air intake vents constructed at front of the bottom panel that has underlay to provide space for adequate airflow. The main processing board is mounted onto the bottom panel in the system. An enclosure containing the central processing unit (CPU) and board components are connected to a plurality of fins constructed laterally to collect the heat generated. The fins have an intake air fan attached to pull in cool air. A centrifugal type exhaust fan positioned between the fins and the back panel of the system with air vents constructed. The cool air enters the computer system thru the air intake vents and mix with the heated air from other internal components. The cool air and the internal heated air then, pass the plurality of fins thru the intake air fan, cool the fins to provide heat dissipation effect for the CPU and main processing board. The heated air departing the plurality of fins then enters the centrifugal type exhaust fan and exit thru the back panel air vents.

## Description

### BACKGROUND OF THE INVENTION

The present invention relates generally to an integrated heat dissipation assembly for computer systems, and more particularly, for computer systems of smaller structural dimensions. This heat dissipation assembly integrates both the heat dissipation of the central processing unit (CPU) and the overall heat dissipation of the entire interior of a computer system.

As the capability of the computer systems continue to advance, the requirement for more effective heat dissipation continues to rise as well. The sources of heat generated from a computer system are still mainly led by the CPU. The other system peripherals, such as supporting chipsets (specifically Northbridge chipset), graphic display chipsets, hard drives, media burners and RAM memory modules are producing significant amount of heat as well, as their capabilities have greatly increased. Therefore, led by the CPU, as the heat sources of a computer system continue to increase due to the growing number of newer and more powerful components introduced into it, the heat generated continues to escalate. Furthermore, as more bare-bone and mini bare-bone computer systems, which have more constraint of heat dissipation, continue to replace typical desktop systems, the need for an even more effective heat dissipation method has significantly increased. As a result, the heat dissipation technique used by individual components is no longer keeping up with the demand and components are relying more on the whole system heat dissipation process to satisfy the requirement.

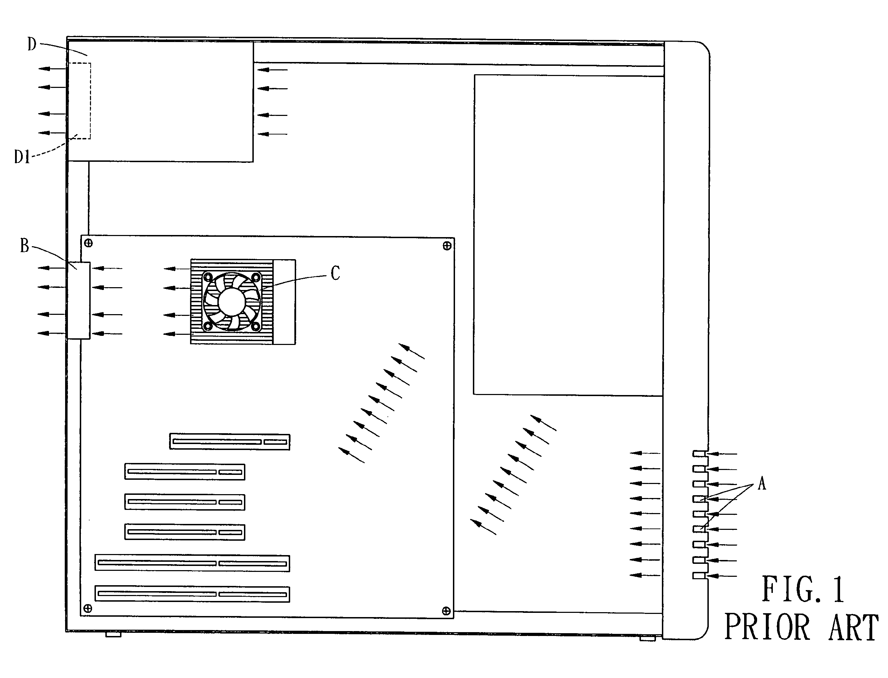

As shown in Figure 1, a structural design of a typical medium-to-large computer system, the heat dissipation process relies on several components: front panel (A) has open vents for air to enter, back panel (B) has an attached fan, CPU has a cooling fan (C) positioned between (A) and (B), an internal power supply (D) mounted onto top and back panels with a fan (D1) attached in back of the power supply. This design, which produces a forced airflow, allows exterior cool air to enter from the front vents, flowing by the CPU to mix with the heated air from the CPU fan (C), and exit the system through fans (B) and (D1). In a smaller system, the heat dissipation process is similar to a medium or big system, except that in a smaller system the main processing board is usually mounted horizontally to the bottom panel of the system, therefore the heat dissipation from the CPU fan (C) disperses in random direction and has no integration with fans (B) and (D1). The result is a less effective heat dissipation process with heat still circulating inside the system. Additionally, for a smaller system, the front panel provides access for various storage devices as well as access control buttons and may not have room for additional vents. If the vents were to be constructed on the side panels, it would, affect the overall appearance of the system and usefulness of the vents if the system were placed against the wall, and instigate a limitation on the users.

### BRIEF SUMMARY OF THE INVENTION

The present invention provides an integrated heat dissipation assembly for a computer system. The heat dissipation assembly presents a more effective and integrated approach by combining the heat dissipation requirement of the CPU and the heat dissipation requirement of a computer system. The present invention, by utilizing unallocated areas of a system's exterior panels will, satisfy a system's airflow need, enhance the overall exterior appearance and provide users more flexibility of positioning the system.

In one preferred embodiment of the present invention, the air intake vents are constructed at the bottom panel near the joint with the front panel of a computer casing. An intake air fan is mounted in front of a plurality of CPU fins. The fins, encased in an enclosure, is then joined to a centrifugal type box fan and the box fan is attaching to the back panel of the system with air vents for airflow. The current invention will enable the cool air to, enter from the intake vents at the bottom panel of the system, mix with heated air generated by internal system peripherals, pass thru the intake air fan and be piped thru the plurality of fins which collects the heat of the CPU and main board components, and finally exit the back panel air vents thru the enclosure exhaust fan element. The current invention provides a more efficient and integrated heat dissipation and airflow design.

These and other objectives of the present invention will become obvious to those of ordinary skill in the art after reading the following detailed description of preferred embodiments.

It is to be understood that both the foregoing general description and the following detailed description are exemplary, and are intended to provide further explanation of the invention as claimed.

### BRIEF DESCRIPTION OF THE DRAWINGS

These, as well as other features of the present invention, will become more apparent upon reference to the drawings wherein:
Figure 1 shows a side view of the prior architecture of a computer system and the heat dissipation flow;
Figure 2 shows a partial perspective view of architecture of a computer system according to the present invention;
Figure 3 shows a side view of the architecture and heat dissipation flow of the present invention;
Figure 4 shows a top view of the architecture of the present invention; and
Figure 5 shows a top view of the heat dissipation fin set for CPU according to another embodiment.

### DETAILED DESCRIPTION OF THE INVENTION

Reference will now be made in detail to the preferred embodiments of the present invention, examples of which are illustrated in the accompanying drawings. Wherever possible, the same reference numbers are used in the drawings and the description to refer to the same or like parts.

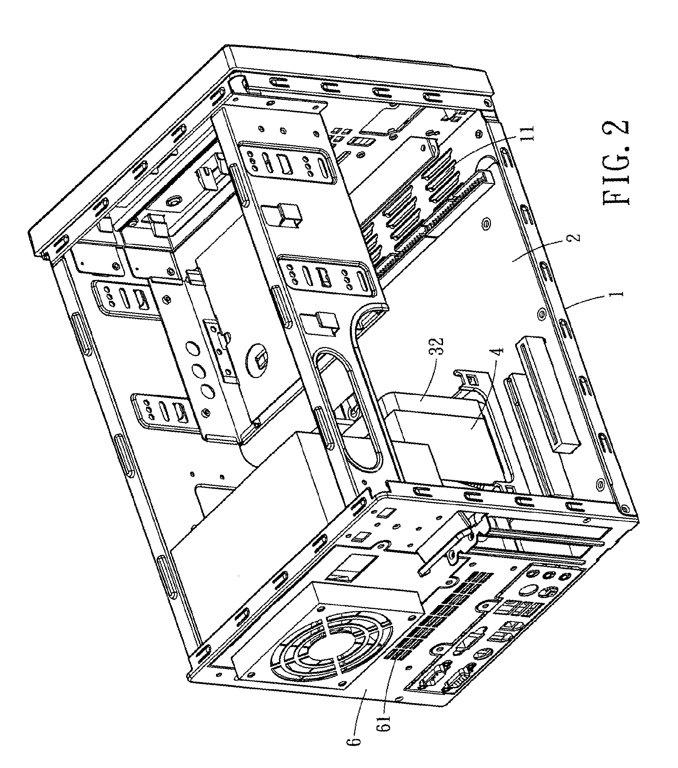

Figures 2, 3 and 4 show the perspective view, side view, and top view of a computer architecture according to the present invention. As shown in Figure 2, a main processing board (2) is mounted onto the bottom panel (1) of a computer casing. A plurality of air intake vents (11) are constructed on the bottom panel (1) near the front joint with the front panel of the casing or, in another case, on the sides thereof close to the front panel.

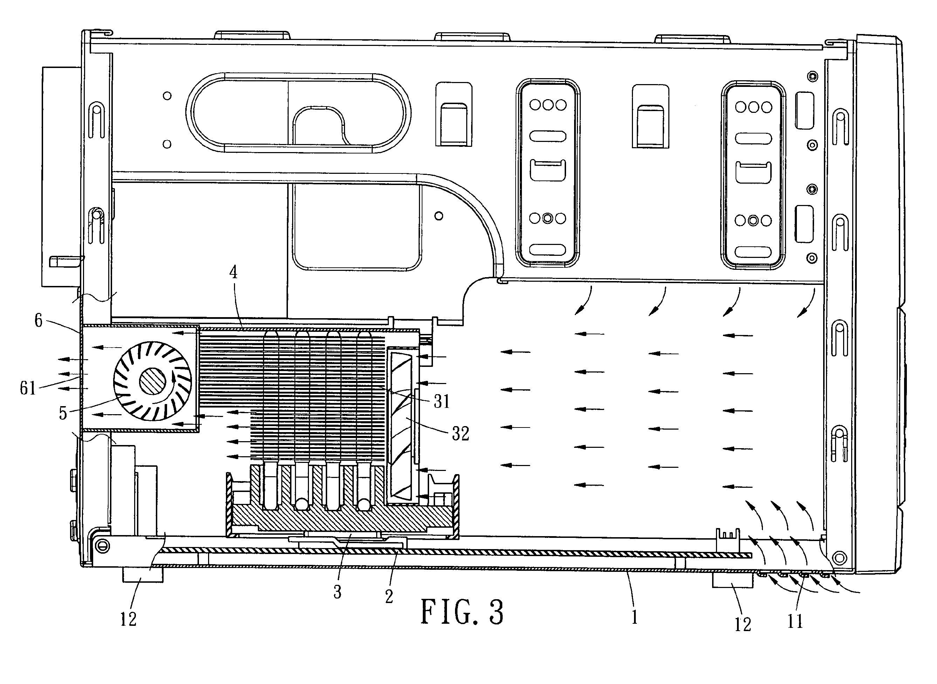

As shown in Figure 3, the mounted main processing board (2) does not obstruct the air intake vents (11). The bottom panel (1) uses attached underlay (12) to elevate the computer system frame to ensure adequate space for airflow. Main processing board (2) is of typical dimension for smaller computer system and is mounted horizontally onto the bottom panel (1). The CPU (3) is mounted onto the main processing board (2) close to the back. The CPU (3) has a plurality of fins (31) attached above it for heat dissipation. The fins (31) are constructed with individual fin joined laterally to form an air channel for horizontal airflow pattern, and is encased by an enclosure (4). In front of the fins (31) is an axial-type air intake fan (32) to pull air into the fins (31). The air will be forced to flow passing the fins (31) which are encased by the enclosure (4) and will not disperse in random directions and can only exit thru the back of the fins (31). Therefore, by positioning the intake air fan (32) in front of the fins (31), the fan can direct cool air into the fins (31) to cool the CPU and main processing board; it can as well produce a constant airflow pattern to cool other internal system peripherals. At the end of the fins (31), a boxed exhaust fan (5) is attached to it. The fins (31) extend partially or fully into the air intake of the exhaust fan (5). The exhaust fan (5) is attached to the back panel (6) of the system that has air vents (61) constructed, and the air pulled in by the exhaust fan (5) can exit the system via the back air vents (61).

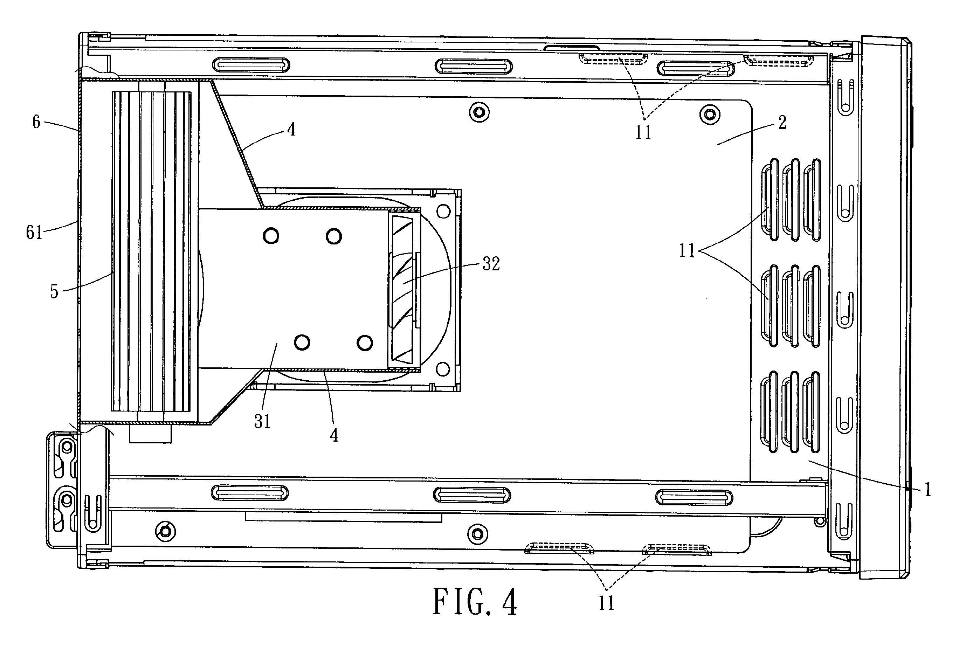

As show in Figure 4, the enclosure (4), with the back attached to the exhaust fan (5), can be custom constructed to fully complement the shape of the exhaust fan and form a wind tunnel. The heated air in the fins (31), encased by the enclosure (4), can then be directed to exit the computer system thru the exhaust box fan (5).

This integrated heat dissipation assembly will utilize intake air fan (32) to pull in cool exterior air thru air intake vents (11). The air pulled in by intake air fan (32), flows thru the plurality of fins (31) to absorb the heat, enters the exhaust fan (5) and is forced out thru the air vents (61) in the back panel (6) of the system. The architecture creates a nearly enclosed channel of forced airflow that develops a pressure imbalance between the interior and exterior of the computer system. The slightly lower interior pressure will force the cooler exterior air to continually enter the computer system and achieve more effective heat dissipation.

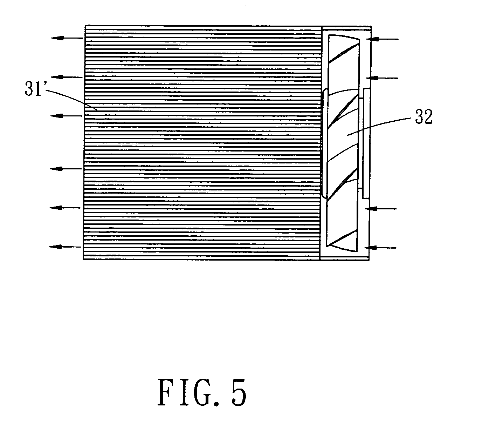

As shown in Figure 5 is the top view of the fins (31) for heat dissipation according to another preferred embodiment. This alternate design calls for the fins (31) to be assembled laterally with individual fins joined vertically. The exhaust fan (5) is attached to the back of the fins (3 1) and the airflow continues to be in a lateral pattern. The exhaust fan (5) is not limited to be centrifugal type. The centrifugal type exhaust fan (5) can provide better results for smaller computer systems with smaller back panel (6). For computer systems with larger dimension or larger back panel (6), an axial-type exhaust fan (5) will offer similar result. The preset invention is also suitable for a computer system with frame that requires a main processing board (2) to be mounted vertically and achieve similar heat dissipation result.

Other embodiments of the present invention will appear to those skilled in the art from consideration of the specification and practice of the invention disclosed herein. It is intended that the specification and examples to be considered as exemplary only, with a true scope and spirit of the present invention being indicated by the following claims.

## Claims

1. An integrated heat dissipating assembly for a computer system, comprising:
a casing, including a front, a bottom and a back panels, constructed with a underlay below the bottom panel, and an air inlet at a front side of the bottom panel;
a main processing board, containing a central processing unit and mounted onto the bottom panel;
a plurality of fins, containing an air channel formed therebetween, positioned above the central processing unit;
an air intake fan, positioned in front of the plurality of fins, to pull cool air thru the air inlet into the air channel;
an exhaust fan, mounted onto the back panel, to discharge heated air thru the fins outward; and
an enclosure, covering the fins from side to side, joining the exhaust fan at its air intake.

2. The assembly of claim 1, wherein the fins are constructed and joined laterally or longitudinally.

3. The assembly of claim 1, wherein the exhaust fan is either centrifugal type or axial type.

4. The assembly of claim 1, wherein the air intake fan is axial type.

5. The assembly of claim 1, wherein the main processing board is mounted horizontally to the bottom panel and does not block the cool air from the air inlet.

6. The assembly of claim 1, wherein the fins are fully or partially extended to the air intake of the exhaust fan.

7. The assembly of claim 1, wherein the air intake vents are constructed on the bottom panel near the front joint with the front panel or, on the side of the bottom panel close to the front panel.

8. The assembly of claim 1, wherein the underlay elevates the bottom panel to ensure adequate space for the cool air flowing thru the air inlet.
